# EUROPÄISCHE PATENTSCHRIFT

(11) **EP 2 702 334 B1**
(45) Veröffentlichungstag und Bekanntmachung des Hinweises auf die Patenterteilung: **27.02.2019**
(21) Anmeldenummer: 12721160.5
(22) Anmeldetag: 30.04.2012
(51) Int. Cl.: F24S 10/40, F24S 23/74, F24S 80/50, F24S 30/425, F24S 20/50, H02S 20/00

(54) **VORRICHTUNG ZUR KONZENTRATION VON SONNENSTRAHLUNG IN EINEM ABSORBER**
DEVICE FOR CONCENTRATING SOLAR RADIATION IN AN ABSORBER
DISPOSITIF POUR LA CONCENTRATION DU RAYONNEMENT SOLAIRE DANS UN ABSORBEUR

(30) Priorität: 29.04.2011 AT 6052011
(43) Veröffentlichungstag der Anmeldung: 05.03.2014
(73) Patentinhaber: Heliovis AG, 2351 Wiener Neudorf (AT)
(72) Erfinder: STÖGER, Elmar, A-2822 Bad Erlach (AT); MUNZENRIEDER, Gerald, A-7143 Apetlon (AT)
(74) Vertreter: Sonn & Partner Patentanwälte
(86) Internationale Anmeldenummer: PCT/AT2012/000119
(87) Internationale Veröffentlichungsnummer: WO 2012/145774

(56) Entgegenhaltungen:
- WO-A2-2009/117840
- CH-A1- 699 605
- US-A1- 2004 055 594
- US-A1- 2010 229 850

## Beschreibung

Die Erfindung betrifft eine Vorrichtung zur Konzentration von Sonnenstrahlung in einem Absorber, mit einem aufblasbaren Konzentrator-Kissen, das ein lichtdurchlässiges Eintrittsfenster zum Einkoppeln der Sonnenstrahlung und eine das Konzentrator-Kissen in zumindest zwei Hohlräume unterteilende Reflektorfolie aufweist, wobei die Reflektorfolie dazu eingerichtet ist, die Sonnenstrahlung in dem Absorber, der im Hohlraum des Konzentrator-Kissens angeordnet ist, zu konzentrieren und mit einem außerhalb des Konzentrator-Kissens angeordneten Verankerungsgerüst zur Verankerung des Konzentrator-Kissens.

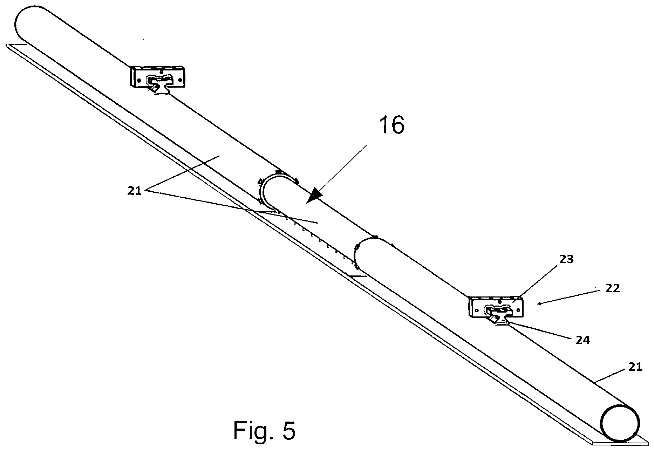

Aus der WO 2009/117840 A2 ist ein Parabolrinnenkollektor mit einer Tragstruktur bekannt, die einen rechteckigen Rahmen aufweist, der in einer Schwenkeinrichtung gelagert ist. Die Verschwenkeinrichtung ermöglicht es, den Kollektor dem jeweiligen Sonnenstand nachzuführen. Gemäß der in Fig. 5 dargestellten Ausführungsform ist eine Druckzelle mit zwei Druckräumen vorgesehen, welche durch einen Konzentrator gebildet sind. Der Konzentrator reflektiert die einfallende Sonnenstrahlung auf einen Sekundärkonzentrator, welcher die derart vorkonzentrierte Strahlung gegen einen sekundären Brennlinienbereich am Ort einer Absorberleitung konzentriert, die innerhalb der Druckzelle angeordnet ist. Die Absorberleitung ist hierbei über ein Trägerfachwerk an Halteplatten des Rahmens abgestützt, welche in dem außerhalb des Kollektors angeordneten Rahmen eingeklemmt sind.

US 2010/0229850 A1 beschreibt einen aufblasbaren Sonnenkollektor mit einer Reflektorfolie, welche den Kollektor in zwei Druckräume unterteilt. Der Kollektor ist in einem Rahmen gelagert, welcher mehrere den Kollektor umgebende Ringe aufweist, die zur Nachführung des Kollektors verschwenkbar gelagert sind. Der Absorber ist hierbei außerhalb des Kollektors angeordnet.

Aus der CH 699 605 A1 und US 2004/0055594 A1 sind weitere aufblasbare Sonnenkollektoren bekannt.

In der AT 505 075 B1 ist ein aufblasbarer Sonnenkollektor in Form eines zylindrischen Schlauchs beschrieben. Der an seiner Oberseite durchsichtige Schlauch wird durch eine Reflektormembran in zwei Kammern unterteilt. Die an ihrer Oberseite verspiegelte Reflektormembran erstreckt sich im Wesentlichen entlang des gesamten Schlauches. Zur Umwandlung der Sonnenenergie ist in der Kammer oberhalb der Reflektormembran ein in Längsrichtung des Sonnenkollektors angeordneter Absorber vorgesehen, welcher beispielsweise als mediumdurchströmte Röhre ausgeführt sein kann; alternativ kann der Absorber durch Photovoltaikelemente gebildet sein. Die Sonnenstrahlung wird von der Reflektormembran in Richtung des Absorbers reflektiert, wodurch beispielsweise ein Medium im Absorber erhitzt wird. Zur terrestrischen Energiegewinnung wird der Sonnenkollektor in einer günstigen Position zum Sonnenstand angeordnet und dem Sonnenlauf nachgeführt. Hierfür ist der Sonnenkollektor mittels Auflagerrollen um seine Längsachse verschwenkbar gelagert. Zudem sind am Sonnenkollektor Verankerungsbänder befestigt.

In den bisherigen Ausführungen wurde der Absorber direkt am aufblasbaren Sonnenkollektor befestigt. Demnach wurde das Gewicht des Absorbers (bzw. einer damit verbundenen Aufhängevorrichtung) allein von der Hülle des Sonnenkollektors getragen, so dass die Hülle im Bereich der Befestigungsstellen des Absorbers am Sonnenkollektor verformt wird. Hierdurch wird die Fokussierung der Sonnenstrahlung durch die Reflektorfolie im Absorber beeinträchtigt. Wenn das durch Druckluft vorgespannte Konzentrator-Kissen den Absorber trägt, kann es je nach Betriebsposition des Konzentrator-Kissens zudem nachteiligerweise zu einem stärkeren Durchhängen des Absorbers kommen; das Gewicht des Absorbers erhöht zudem insgesamt den Durchhang des Konzentrator-Kissens zwischen seinen Auflagerstellen. Die Aufhängung des Absorbers am Konzentrator-Kissen hat somit die nachteilige Auswirkung, dass die von der Reflektorfolie reflektierten Sonnenstrahlen nicht exakt in der Linie des Absorbers gebündelt werden. Somit waren Einbußen in der Energieumwandlung unvermeidbar. Dieses Problem tritt verstärkt bei größeren Sonnenkollektoren dieser Art auf, da das Ausmaß der Eindellung durch die Aufhängung des Absorbers an der Hülle mit dem Durchmesser der Hülle zunimmt.

Demzufolge besteht die Aufgabe der vorliegenden Erfindung darin, eine Vorrichtung der eingangs angeführten Art zu schaffen, welche hinsichtlich der vorstehend erläuterten Probleme verbessert sind. Demnach soll der Absorber im Betrieb mit hoher Genauigkeit im Fokusbereich der Reflektorfolie angeordnet werden, wobei eine Verformung des Konzentrator-Kissens zuverlässig vermieden werden soll.

Diese Aufgabe wird bei der Vorrichtung der eingangs angeführten Art durch die Merkmale des kennzeichnenden Teils von Anspruch 1 gelöst, wonach der Absorber mittels einer Absorberaufhängung an dem Verankerungsgerüst befestigt ist, wobei das Konzentrator-Kissen im lichtdurchlässigen Eintrittsfenster zumindest eine allseitig abgedichtete Befestigungsöffnung zum Durchtritt der Absorberaufhängung aufweist, wobei die Absorberaufhängung eine außerhalb des Konzentrator-Kissens angeordnete Trageinrichtung, die mit dem Verankerungsgerüst verbunden ist, und eine innerhalb des Konzentrator-Kissens angeordnete Absorberhalterung, die mit dem Absorber verbunden ist, aufweist, wobei die außerhalb des Konzentrator-Kissens angeordnete Trageinrichtung und die innerhalb des Konzentrator-Kissens angeordnete Absorberhalterung der Absorberaufhängung über die allseitig abgedichtete Befestigungsöffnung des Konzentrator-Kissens im lichtdurchlässigen Eintrittsfenster miteinander verbunden sind.

In den abhängigen Ansprüchen sind bevorzugte Ausführungsformen der Erfindung angegeben.

Demnach wird der Absorber über die Absorberaufhängung an dem außerhalb des Konzentrator-Kissens befindlichen Verankerungsgerüst aufgehängt, so dass das Gewicht des Absorbers bzw. der Absorberaufhängung in einer montierten Betriebsstellung der Vorrichtung durch das Verankerungsgerüst getragen wird. Hierfür weist das Verankerungsgerüst eine ausreichende Steifigkeit bzw. Stabilität auf, was beispielsweise durch eine Metallkonstruktion erreicht wird. Durch die Anbindung des Absorbers an das Verankerungsgerüst kann einer Verformung der Konzentrator-Hülle zuverlässig vorgebeugt werden, so dass der Absorber mit hoher Genauigkeit im Fokusbereich der Reflektorfolie positionierbar ist. Hierdurch kann die Effizienz in der Energieumwandlung beträchtlich gesteigert werden. Wenn eine gleichmäßige Aufhängung des Absorbers am Verankerungsgerüst sichergestellt ist, kann zudem ein Durchhängen des Absorbers unter seinem Eigengewicht verringert werden, so dass der Absorber über seine gesamte Länge im Fokus der Reflektorfolie angeordnet ist. Hierdurch kann die Energieausbeute im Betrieb weiter erhöht werden. Indem ein bereits vorhandenes Verankerungsgerüst zusätzlich zur Aufhängung des Absorbers genützt wird, kann zudem eine konstruktiv einfache, teilesparende Ausführung erzielt werden, welche sich durch niedrige Errichtungskosten auszeichnet.

Zur stabilen Aufhängung des Absorbers am Verankerungsgerüst weist die Absorberaufhängung eine außerhalb des Konzentrator-Kissens angeordnete Trageinrichtung, die mit dem Verankerungsgerüst verbunden ist, und eine innerhalb des Konzentrator-Kissens angeordnete Absorberhalterung, die mit dem Absorber verbunden ist, auf. Zur Verbindung der außerhalb des Konzentrator-Kissens angeordneten Trageinrichtung der Absorberaufhängung mit der innerhalb des Konzentrator-Kissens angeordneten Absorberhalterung sind die außerhalb des Konzentrator-Kissens angeordnete Trageinrichtung und die innerhalb des Konzentrator-Kissens angeordnete Absorberhalterung der Absorberaufhängung über eine allseitig abgedichtete Befestigungsöffnung des Konzentrator-Kissens miteinander verbunden. Die Befestigungsöffnung des Konzentrator-Kissens ist zweckmäßigerweise im Bereich des Eintrittsfensters vorgesehen, welches vorzugsweise durch eine transparente (Kunststoff-)Folie gebildet ist. Hierfür ist es günstig, wenn das Eintrittsfenster zwei im Wesentlichen parallel verlaufende Folienbahnen aufweist, wobei die Befestigungsöffnung zwischen den Folienbahnen ausgebildet ist ; die Absorberhalterung ist je nach Ausführung in bestimmten Abständen oder über die gesamte Länge der Absorberaufhängung an die Trageinrichtung (und somit an das Verankerungsgerüst) angebunden. Hierdurch kann eine gleichmäßige Abstützung des Absorbers entlang seiner Längserstreckung gewährleistet werden.

Bei einer bevorzugten Ausführungsform der Erfindung ist vorgesehen, dass die Absorberaufhängung mit einem Nachführungssystem des Verankerungsgerüsts verbunden ist, welches dazu eingerichtet ist, das Konzentrator-Kissen um zumindest eine Achse schwenkbar zu lagern. Das Nachführungssystem des Verankerungsgerüsts dient zur Nachführung des Konzentrator-Kissens an den Sonnenlauf, um das Konzentrator-Kissen im Betrieb in einer günstigen Stellung zur Sonne zu positionieren. Hierfür ist es günstig, wenn das Konzentrator-Kissen mittels des Nachführungssystems um eine Längsachse des Konzentrator-Kissens verschwenkbar gelagert ist.

Zur Anbindung der Absorberaufhängung an das Nachführungssystem des Verankerungsgerüsts ist es günstig, wenn die Absorberaufhängung mit zumindest einem das Konzentrator-Kissen umgebenden Nachführungsring, vorzugsweise mit mehreren in Längsrichtung des Konzentrator-Kissens beabstandet angeordneten Nachführungsringen, verbunden ist. In der Betriebsstellung der Vorrichtung wird der Absorber über die Absorberaufhängung von dem zumindest einen Nachführungsring des Nachführungssystems getragen, welcher das Konzentrator-Kissen zumindest teilweise umgibt. Um eine gleichmäßige Aufhängung des Absorbers zu erzielen, sind vorzugsweise mehrere über die Länge des Konzentrator-Kissens verteilt angeordnete Nachführungsringe vorgesehen, welche jeweils über die Absorberaufhängung mit dem Absorber verbunden sind. Jeder Nachführungsring kann dabei aus mehreren einzelnen Ringen zusammengesetzt sein, wodurch eine besonders stabile, gewichtssparende Konstruktion erzielt wird. Zur selbsttätigen Nachführung des Konzentrator-Kissens an den Sonnenlauf ist es von Vorteil, wenn die Nachführungsringe mittels eines Antriebs um ihre zentrale Achse, die vorzugsweise im Wesentlichen mit der Längsachse des Konzentrator-Kissens zusammenfällt, drehbar gelagert sind.

Um thermisch bedingte Längenänderungen der Absorberaufhängung relativ zum Verankerungsgerüst kompensieren zu können, ist es von Vorteil, wenn die Absorberaufhängung in Längsrichtung des Absorbers verschieblich an dem Verankerungsgerüst, insbesondere am Nachführungsring, gelagert ist. Im Betrieb der Vorrichtung kann die Absorberaufhängung anderen Längenausdehnungen als das Verankerungsgerüst unterworfen sein. Eine Ursache hierfür besteht darin, dass die thermischen Ländenausdehnungen in der Absorberaufhängung bzw. in dem Verankerungsgerüst in unterschiedliche Richtungen wirken können. Zudem können lokale Temperaturunterschiede auftreten, welche das Ausmaß der Längenänderungen im Bereich des Verankerungsgerüsts bzw. der Absorberaufhängung beeinflussen. Die Abweichungen zwischen den im Betrieb auftretenden Längenänderungen können nun durch eine relative Verschiebung der Absorberaufhängung gegenüber dem Verankerungsgerüst berücksichtigt werden.

Zur verschieblichen Lagerung der Absorberaufhängung am Verankerungsgerüst ist es günstig, wenn zwischen dem Nachführungssystem und der Absorberaufhängung ein Lineargleitlager ausgebildet ist, welches einen an dem Verankerungsgerüst oder an der Absorberaufhängung fixierten Schlitten und eine entsprechende, an der Absorberaufhängung bzw. am Nachführungssystem fixierte Führungsschiene aufweist. Je nach Ausführung ist somit auch eine vertauschte Anordnung von Schlitten und Führungsschiene an der Absorberaufhängung bzw. am Verankerungsgerüst möglich. Alternativ können auch andere Lagertypen, beispielsweise ein Rolllager, vorgesehen sein.

Zur gleichmäßigen, stabilen Aufhängung des Absorbers über die Länge des Absorbers ist es günstig, wenn die Trageinrichtung der Absorberaufhängung zumindest ein rohrförmiges Tragelement, insbesondere mehrere jeweils an ihren Endbereichen ineinandergesteckte rohrförmige Tragelemente, aufweist. Rohrförmige Tragelemente zeichnen sich durch hohe Steifigkeit bei geringem Gewicht aus. Die Steifigkeit eines solchen rohrförmigen Tragelements ist zudem richtungsunabhängig, so dass in jeder Stellung des Konzentrator-Kissens, welche insbesondere vom Sonnenstand abhängt, eine minimale Durchbiegung der Absorberaufhängung auftritt.

Da die Trageinrichtung der Absorberaufhängung und die Absorberhalterung im Betrieb unterschiedlichen Temperaturen ausgesetzt sein können und somit unterschiedliche Wärmeausdehnungen aufweisen können, ist es günstig, wenn die außerhalb des Konzentrator-Kissens angeordnete Trageinrichtung und die innerhalb des Konzentrator-Kissens angeordnete Halteeinrichtung der Absorberaufhängung mittels einer Linearführung, insbesondere eines Lineargleitlagers, in Längsrichtung des Absorbers zueinander verschieblich gelagert sind.

Zur Abdichtung der Befestigungsöffnung des Konzentrator-Kissens ist bevorzugt ein Kedersystem vorgesehen. Gemäß einer bevorzugten Ausführung sind hierbei an die Befestigungsöffnung angrenzende Abschnitte des Konzentrator-Kissens um einen Keder umgeschlagen und mittels innenseitig bzw. außenseitig an dem Konzentrator-Kissen angeordneter Klemmplatten der Absorberaufhängung fixiert. Gemäß einer alternativen bevorzugten Ausführung weist das Kedersystem ein Profilelement auf, welches sich entlang der Befestigungsöffnung erstreckt. Die Keder sind hierbei innerhalb des Profilelements angeordnet, welches seitliche Öffnungen zum Durchtritt der an die Befestigungsöffnung angrenzenden Randbereiche des Konzentrator-Kissens aufweist. Beim Aufblasen des Konzentratorkissens werden die Kedern gegen die seitlichen Innenflächen des Profilelements gedrückt, wodurch die Befestigungsöffnung nach außen abgedichtet wird. Somit kann vorteilhafterweise die Abdichtung der Befestigungsöffnung ohne zusätzlichen Montageaufwand erreicht werden.

Zur Abdichtung der Befestigungsöffnung des Konzentrator-Kissens ist es günstig, wenn ein zwischen den Klemmplatten der Absorberaufhängung wirkendes Klemmelement, insbesondere eine Schraube, zur Aufbringung einer Klemmkraft zwischen den Klemmplatten vorgesehen ist. Zudem kann es von Vorteil sein, wenn im Bereich der umgeschlagenen Abschnitte des Konzentrator-Kissens Klebstoffraupen vorgesehen sind, welche das Kedersystem zuverlässig in der vorgesehenen Position halten.

Um das Durchhängen der Absorberaufhängung zwischen benachbarten Nachführungsringen der Nachführungseinrichtung weiter zu verringern bzw. gänzlich zu verhindern, ist es günstig, wenn zwischen dem Verankerungsgerüst und der Absorberaufhängung insbesondere in einem Bereich außerhalb der Verbindungen mit dem Verankerungsgerüst ein Stütz- bzw. Spannsystem angeordnet ist. Hierfür ist es insbesondere von Vorteil, wenn das Stütz- bzw. Spannsystem zumindest ein insbesondere seilförmiges Spannelement aufweist, dessen Enden an der Absorberaufhängung bzw. an dem Verankerungsgerüst, insbesondere an einem mit dem Nachführungsring verbundenen Stützelement, befestigt sind.

Die Erfindung wird nachstehend anhand von den in den Figuren dargestellten Ausführungsbeispielen, auf die sie jedoch nicht beschränkt sein soll, noch weiter erläutert. Im Einzelnen zeigen in der Zeichnung:
Fig. 1 eine schaubildliche Ansicht einer erfindungsgemäßen Vorrichtung zur Konzentration von Sonnenstrahlung in einem Absorber mittels eines Konzentrator-Kissens, wobei der Absorber über eine Absorberaufhängung an einem Verankerungsgerüst befestigt ist;
Fig. 2 einen Ausschnitt des aus Fig. 1 ersichtlichen Konzentrator-Kissens, welches ein lichtdurchlässiges Eintrittsfenster und eine das Konzentrator-Kissen in mindestens zwei Hohlräume unterteilende Reflektorfolie aufweist;
Fig. 3 eine schematische Detailansicht der in Fig. 1 dargestellten Konzentrator-Vorrichtung, wobei die Absorberaufhängung an einem Nachführungsring zum Nachführen des Konzentrator-Kissens an den Sonnenlauf verbunden ist;
Fig. 4 eine schaubildliche Ansicht eines Lineargleitlagers zwischen der Absorberaufhängung und dem Nachführungsring (vgl. Fig. 3) ;
Fig. 5 eine schaubildliche Ansicht einer außerhalb des Konzentrator-Kissens anordenbaren Trageinrichtung der Absorberaufhängung gemäß Fig. 3, welche aus mehreren rohrförmigen Tragelementen aufgebaut ist, die an ihren Endbereichen ineinandergesteckt sind;
Fig. 6 eine Detailansicht der in Fig. 5 dargestellten Trageinrichtung im Verbindungsbereich zweier benachbarter rohrförmiger Tragelemente, wobei der modulartige Aufbau der Trageinrichtung ersichtlich ist;
Fig. 7 eine schaubildliche Ansicht der erfindungsgemäßen Konzentrator-Vorrichtung im Bereich einer allseitig abgedichteten Befestigungsöffnung des Konzentrator-Kissens zur Anbindung der Absorberaufhängung;
Fig. 8 eine Ansicht einer alternativen Ausführung zum dichten Verschließen der Befestigungsöffnung des Konzentrator-Kissens;
Fig. 9a und Fig. 9b jeweils schematische Stütz- bzw. Spannsysteme zur Abstützung der Absorberaufhängung zwischen benachbarten Nachführungsringen;
Fig. 10 schematisch den Durchtritt des Absorbers durch eine ovale bzw. ellipsenähnliche Durchtrittsöffnung an einem stirnseitigen Endbereich des Konzentrator-Kissens, wobei die Durchtrittsöffnung mittels einer Dichteinrichtung abgedichtet ist;
Fig. 11 eine Ansicht der Dichteinrichtung gemäß Fig. 10, welche ein Klemmteil und ein Formteil (nebeneinander dargestellt) aufweist;
Fig. 12 einen Querschnitt durch die Dichteinrichtung entlang der Linie XII-XII in Fig. 11;
Fig. 13 eine Fig. 11 entsprechende Ansicht einer alternativen Ausführung der Dichteinrichtung mit einem in Längsrichtung verschieblichen Zungenabschnitt;
Fig. 14 einen Längsschnitt der erfindungsgemäßen Konzentrator-Vorrichtung im Bereich der stirnseitigen Durchtrittsöffnung für den Absorber; und
Fig. 15 eine schaubildliche Ansicht einer weiteren Ausführungsform der Konzentrator-Vorrichtung.

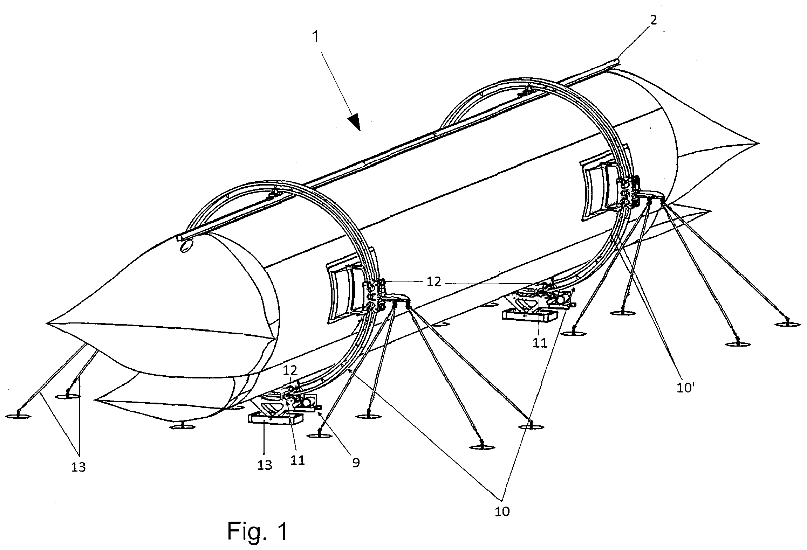

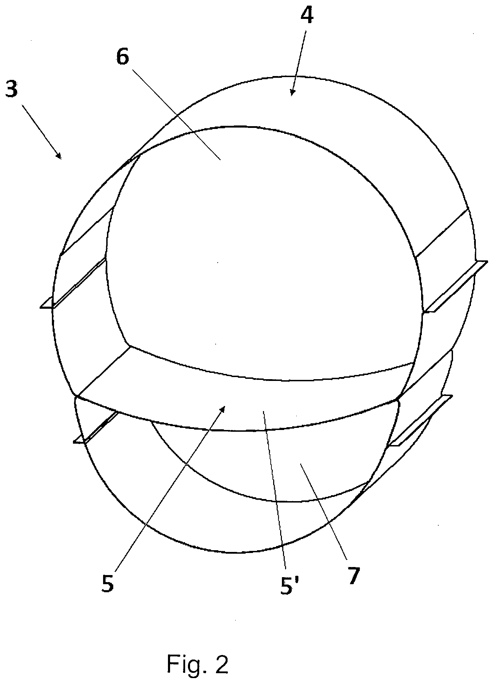

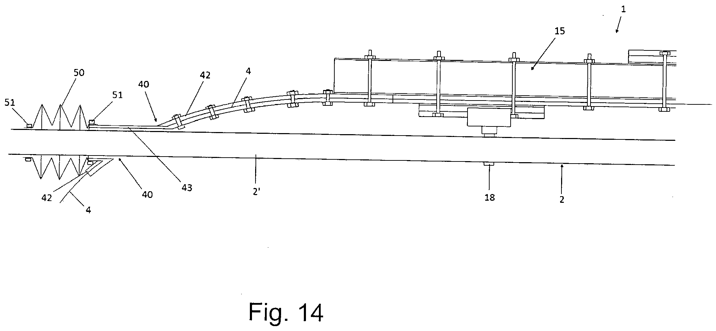

Fig. 1 zeigt eine Vorrichtung 1 zur Konzentration von Sonnenstrahlung in einem Absorber 2. Die Vorrichtung 1 weist ein aufblasbares Konzentrator-Kissen 3 auf, dessen Aufbau aus Fig. 2 ersichtlich ist. Demnach weist das Konzentrator-Kissen 3 eine langgestreckte, im Wesentlichen zylindrische bzw. schlauchförmige Hülle auf, mit einem lichtdurchlässigen Eintrittsfenster 4 zum Einkoppeln der Sonnenstrahlung. Die Hülle wird durch eine Reflektorfolie 5 in zumindest zwei getrennte Hohlräume 6, 7 unterteilt, welche jeweils luftdicht verschlossen sind. Die Reflektorfolie 5 weist eine Spiegelfläche 5' auf, welche die eingekoppelte Sonnenstrahlung in Richtung des Absorbers 2 bündelt. Der Absorber 2 bzw. das Solarpaneel befindet sich im Fokusbereich der Spiegelfläche 5' innerhalb des oberen, an das Eintrittsfenster 4 anschließenden Hohlraums 6 des Konzentrator-Kissens 3. Als Absorber 2 kann insbesondere ein mediendurchströmtes Rohr 2' (vgl. Fig. 14) oder ein Photovoltaikelement vorgesehen sein. Der Konzentrator 1 kann somit sowohl für konzentrierte Photovoltaik (CPV = Concentrated Photovoltaics), als auch für konzentrierte Solarthermie (CSP = Thermal Concentrated Solar Power) verwendet werden. Im Betrieb des Konzentrators 1 wird in den Hohlräumen 6, 7 ein Druckunterschied ausgebildet, wodurch die Reflektorfolie 5 gleichmäßig konkav gewölbt wird, so dass die eingekoppelte Sonnenstrahlung von der Spiegelfläche 5' in den Absorber 2 fokussiert wird. Das Konzentrator-Kissen 3 mit Druckluft in den Hohlräumen 6, 7 ist grundsätzlich selbsttragend ausgelegt, so dass gegenüber herkömmlichen Solarkonzentratoren ein erheblich niedrigeres Gewicht realisierbar ist. Wie aus Fig. 2 ersichtlich, ist das Konzentrator-Kissen 3 aus einzelnen dünnwandigen (Kunststoff-)Folien aufgebaut; für das Eintrittsfenster 4 ist eine transparente Folie vorgesehen.

Wie aus Fig. 1 weiters ersichtlich, ist zur Verankerung des Konzentrator-Kissens 3 ein außerhalb desselben angeordnetes Verankerungsgerüst 8 zur Fixierung des Konzentrator-Kissens 3 in einer vorgegebenen Position vorgesehen. Das Verankerungsgerüst 8 weist vorzugsweise ein Nachführungssystem 9 auf, um das Konzentrator-Kissen 3 im Betrieb dem Sonnenlauf nachzuführen. Hierfür ist das Nachführungssystem 9 dazu eingerichtet, das Konzentrator-Kissen 3 um zumindest eine Achse des Konzentrator-Kissens 3, hier speziell die Längsachse des Konzentrator-Kissens 3, schwenkbar zu lagern. Das Nachführungssystem 9 des Verankerungsgerüsts 8 weist mehrere in Richtung der Längs-Achse 3' des Konzentrator-Kissens 3 beabstandet angeordnete Nachführungsringe 10 auf, welche das Konzentrator-Kissen 3 umschließen. Jeder Nachführungsring 10 besteht aus mehreren (im gezeigten Ausführungsbeispiel jeweils drei) einzelnen Ringen 10', welche mittels Rollvorrichtungen 11 drehbar gelagert sind. Hierfür weist die Rollvorrichtung 11 an den Ringen 10' abrollende Rollen 12 auf. Zur Verschwenkung des Nachführungsrings 10 ist ein Antrieb (nicht dargestellt) vorgesehen. Hierfür kann der Nachführungsring 10 mit einem Zahnriemen verbunden sein, der durch einen Motor (nicht gezeigt) bewegt wird. Zur Verankerung am Untergrund sind verschiedene Verankerungselemente 13 vorgesehen.

Bei bekannten Ausführungen solcher Konzentrator-Vorrichtungen 1 wurde der Absorber 2 unmittelbar am Konzentrator-Kissen 3 aufgehängt. Die Aufhängung des Absorbers 2 am Konzentrator-Kissen 3 führt jedoch nachteiligerweise zu einer Verformung des Konzentrator-Kissens 3 an den Befestigungsstellen; zudem bewirkt das Eigengewicht des Absorbers 2, dass der Absorber 2 am Konzentrator-Kissen 3 durchhängt. Dies hat den nachteiligen Effekt, dass der Absorber 2 im Betrieb nicht exakt im Fokusbereich der Reflektorfolie 5 angeordnet wird, wodurch die Effizienz in der Energieumwandlung beeinträchtigt wird.

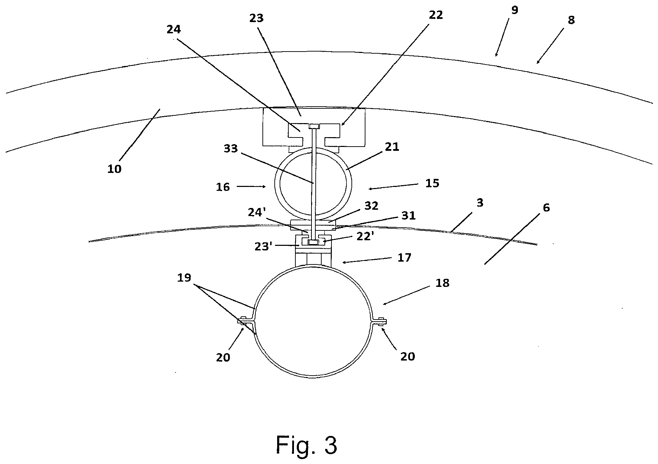

Wie aus Fig. 3 ersichtlich, ist bei der gezeigten Konzentrator-Vorrichtung 1 zur Lösung dieser Problematik vorgesehen, dass der Absorber 2 mittels einer Absorberaufhängung 15 an dem Verankerungsgerüst 8 befestigt ist, so dass das Gewicht des Absorbers 2 bzw. der Absorberaufhängung 15 von dem im Wesentlichen starren Verankerungsgerüst 8 getragen wird. Hierdurch kann einer Verformung des Konzentrator-Kissens 3 und somit einer ungenügenden Fokussierung der eingekoppelten Sonnenstrahlung im Absorber 2 zuverlässig vorgebeugt werden. In der Folge kann der Wirkungsgrad bei der Umwandlung der Sonnenenergie beträchtlich gesteigert werden. Beim gezeigten Ausführungsbeispiel erfolgt die Anbindung der Absorberaufhängung 15 an dem Verankerungsgerüst 8 über die Nachführungsringe 10 des Nachführungssystems 9, welches hierfür geeignete Verbindungsmittel (Schraub-, Schweiß-, Bolzen-Verbindungen etc.) aufweist.

Wie aus Fig. 3 weiters ersichtlich, weist die Absorberaufhängung 15 eine außerhalb des Konzentrator-Kissens 3 angeordnete Trageinrichtung 16 auf, die mit dem Verankerungsgerüst 8, hier mit einem Nachführungsring 10, verbunden ist. Die Absorberaufhängung 15 weist weiters eine innerhalb des Konzentrator-Kissens 3, im Hohlraum 6 angeordnete Absorberhalterung 17 auf, welche mit dem Absorber 2 verbunden ist. Hierfür weist die Absorberhalterung 17 zumindest einen Halterungsring 18 auf, welcher den (in Fig. 3 nicht gezeigten) Absorber 2 umschließt. Der Halterungsring 18 besteht aus zwei Halbschalen 19, die über geeignete Befestigungsmittel 20 (Schrauben, Bolzen, etc.) miteinander verbunden sind.

Wie aus Fig. 3 weiters ersichtlich, weist die mit dem Verankerungsgerüst 8 verbundene Trageinrichtung 16 zumindest ein rohrförmiges Tragelement 21 auf, welches sich durch hohe Steifigkeitswerte bei geringem Gewicht auszeichnet.

Wie aus Fig. 3 weiters ersichtlich, ist zwischen dem Nachführungssystem 9 und der Absorberaufhängung 15 ein Lineargleitlager 22 ausgebildet, so dass die Absorberaufhängung 15 in Längsrichtung des Absorbers 2 verschieblich an dem Verankerungsgerüst 9 bzw. an dem Nachführungsring 10 gelagert ist. Hierdurch können temperaturabhängige Längenänderungen zwischen der Absorberaufhängung 15 und dem Verankerungsgerüst 8, hier dem Nachführungsring 10, kompensiert werden.

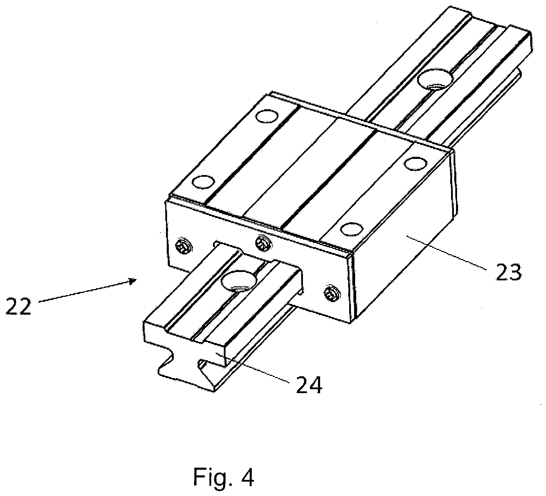

Wie aus Fig. 3 und in größerem Detail aus Fig. 4 ersichtlich, ist zur verschieblichen Lagerung zwischen Absorberaufhängung 15 und Nachführungssystem 9 ein an dem Verankerungsgerüst 8 (beim gezeigten Ausführungsbeispiel am Nachführungsring 10) befestigter Schlitten 23 vorgesehen, welcher gegenüber einer entsprechenden, an der Trageinrichtung 16 der Absorberaufhängung 15 fixierten Führungsschiene 24 verschieblich gelagert ist. Die Führungsschiene 24 weist ein im Wesentlichen einer Ausnehmung im Führungsschlitten 23 entsprechendes Querschnittsprofil auf.

Da die Absorberhalterung 17 und die Trageinrichtung 16 im Betrieb der Vorrichtung 1 unterschiedliche Längenänderungen infolge von Temperaturschwankungen erfahren können, ist ein weiteres Lineargleitlager 22' vorgesehen, welches die Trageinrichtung 16 und die Absorberhalterung 17 verschieblich zueinander lagert. Das Lineargleitlager 22' kann entsprechend dem Lineargleitlager 22 zwischen der Trageinrichtung 16 und dem Nachführungssystem 9 ausgebildet sein (vgl. Fig. 4). Hierfür weist das weitere Lineargleitlager 22' einen an der Absorberhalterung 17 fixierten Führungs-Schlitten 23' auf, welcher gegenüber einer Führungsschiene 24' verschieblich gelagert ist.

Fig. 5 zeigt eine Detailansicht der Trageinrichtung 16 der Absorberaufhängung 15 mit dem Lineargleitlager 22, bestehend aus Schlitten 23 und Führungsschiene 24. Weiters weist die Trageinrichtung 16 mehrere jeweils an ihren Endbereichen ineinandergesteckte rohrförmige Tragelemente 21 auf. Hierfür weisen benachbarte Tragelemente 21 einen unterschiedlichen Durchmesser auf, so dass die Tragelemente 21 ineinander passen.

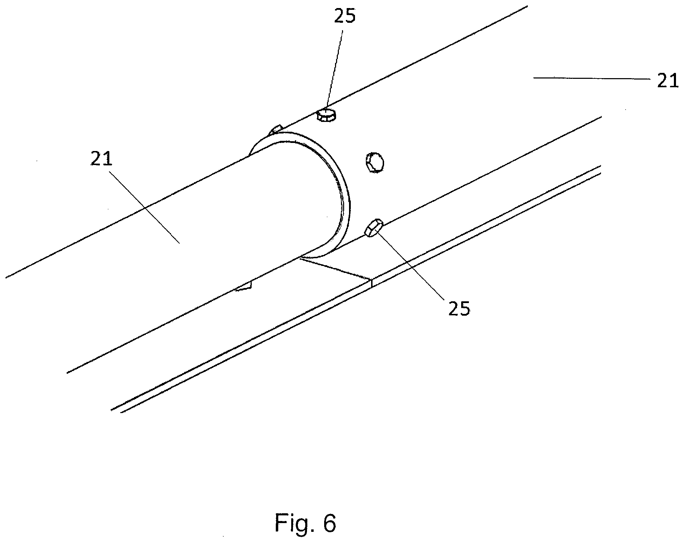

Wie aus Fig. 6 ersichtlich, sind die rohrförmigen Tragelemente 21 lösbar miteinander verbunden, so dass ein modulartiger Aufbau der Trageinrichtüng 16 möglich ist. Je nach Länge des Konzentrator-Kissens 3 kann somit eine entsprechende Anzahl von rohrförmigen Tragelementen 21 miteinander verbunden werden. Zur lösbaren Verbindung der rohrförmigen Tragelemente 21 können beispielsweise Schraubverbindungen 25 vorgesehen sein.

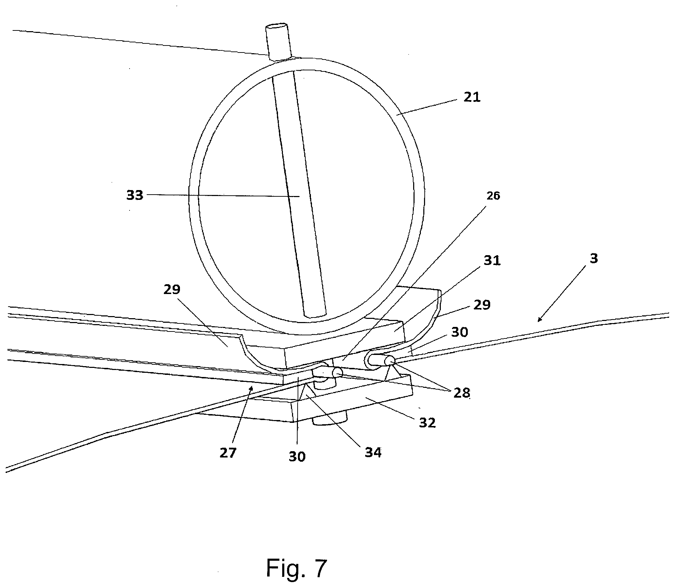

Wie aus Fig. 7 ersichtlich, weist das Konzentrator-Kissen 3 zur Anbindung des Absorbers 2 an das Verankerungsgerüst 8 eine Befestigungsöffnung 26 auf, welche sich beim gezeigten Ausführungsbeispiel im Bereich des Eintrittsfensters 4 des Konzentrator-Kissens 3 befindet. Die Trageinrichtung 16 und die Absorberhalterung 17 sind über die Befestigungsöffnung 26 miteinander verbunden. Um einen Luftaustritt aus dem Hohlraum 6 des Konzentrator-Kissens 3 zu vermeiden, ist die Befestigungsöffnung 26 allseitig abgedichtet. Hierfür ist bei der Ausführung gemäß Fig. 7 ein Kedersystem 27 vorgesehen. Das Kedersystem 27 weist benachbart der Befestigungsöffnung 26 angeordnete Keder 28 auf. Die Ränder der transparenten Membran des Konzentrator-Kissens 3 sind um die Keder 28 umgeschlagen, so dass Kederfahnen 29 gebildet sind. Die Kederfahnen 29 sind jeweils mittels eines Klebebands 30, vorzugsweise aus einem Schaumstoff-Material, zwischen den umgeschlagenen Abschnitten der transparenten Membran fixiert. Weiters erleichtern die Kederfahnen 29 das Greifen und Handhaben der transparenten Folie während des Montagevorganges, insbesondere beim Positionieren des Keders zwischen den beiden Klemmplatten 31, 32.

Wie aus Fig. 7 weiters ersichtlich, sind die Kederfahnen 29 zwischen Klemmplatten 31 (vgl. auch Fig. 3) der Absorberaufhängung 15 eingeklemmt. Die Klemmplatten 31, 32 sind mit der Trageinrichtung 16 bzw. mit der Absorberhalterung 17 verbunden. Zur Aufbringung einer geeigneten Klemmkraft zwischen den Klemmplatten 31, 32 ist ein durch das rohrförmige Tragelement 21 und die Klemmplatten 31, 32 durchragendes Klemmelement in Form einer Schraube 33 vorgesehen, welche je nach Klemmkraft entsprechend angezogen ist. Um ein Verrutschen des Kedersystems 27 zwischen den Klemmplatten 31, 32 zu verhindern, sind zudem beidseitig der Befestigungsöffnung 26 Klebstoffraupen 34 vorgesehen, welche beispielsweise an der Innenseite der unteren, mit der Absorberhalterung 17 verbundenen Klemmplatte 31 angeordnet sind.

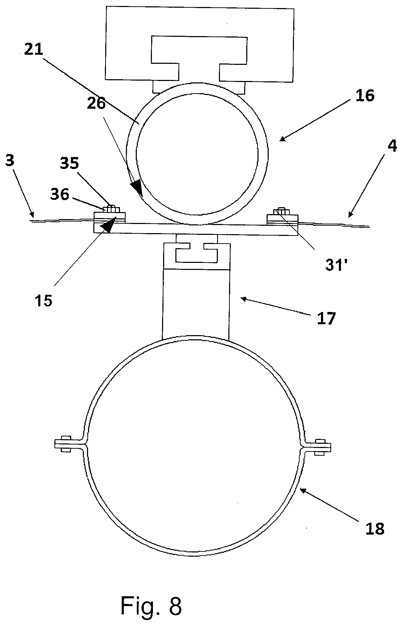

In Fig. 8 ist eine alternative Ausführung zum dichten Verschließen der Befestigungsöffnung 26 im transparenten Eintrittsfenster 4 des Konzentrator-Kissens 3 gezeigt. Wie aus Fig. 8 ersichtlich, sind an den Rändern der transparenten Folie des Eintrittsfensters 4 Löcher vorgesehen, in welche mit einer Platte 31' der Absorberaufhängung 15 verbundene Befestigungsmittel 35 (beispielsweise Schrauben oder Bolzen) eingehängt sind. Die gelochten Abschnitte des Eintrittsfensters 4 werden unter Zwischenlage von Dichtungen abgedichtet und mittels Schraubenmuttern 36 verklemmt.

Die Anbindung des Absorbers 2 an das Verankerungsgerüst 8 erfolgt vorzugsweise an jedem in Längsrichtung des Konzentrator-Kissens 3 beabstandet angeordneten Nachführungsring 10, wobei jeweils eine (insbesondere gemäß Fig. 7 bzw. Fig. 8) allseitig abgedichtete Befestigungsöffnung 26 im Konzentrator-Kissen 3 vorgesehen ist, um die innerhalb des Konzentrator-Kissens 3 angeordnete Absorberhalterung 17 mit der außerhalb des Konzentrator-Kissens 3 angeordneten Trageinrichtung 16 zu verbinden.

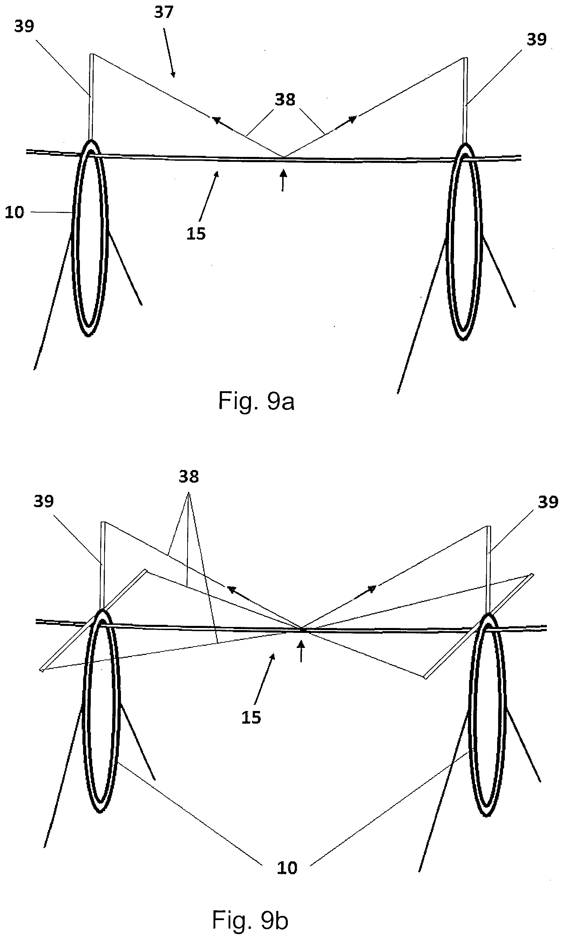

Wie aus den Fig. 9a und 9b ersichtlich, kann zudem ein Stütz- bzw. Spannsystem 37 vorgesehen sein, um eine durch das Eigengewicht der Absorberaufhängung 15 hervorgerufene Verformung bzw. Durchhängung zwischen benachbarten Nachführungsringen 10 zu verringern. Hierfür weist das Stütz- bzw. Spannsystem 37 mehrere seilförmige Spannelemente 38 auf, deren freie Enden jeweils an der Absorberaufhängung 15 bzw. einem Stützelement 39 des Verankerungsgerüsts 8 befestigt sind.

Gemäß Fig. 9a sind im Wesentlichen vertikal angeordnete Stützelemente 39 vorgesehen, die an den Nachführungsringen 10 befestigt sind. Die freien Enden der seilförmigen Spannelementen 38 sind mit den freien Enden der Stützelemente 39 bzw. mit der Absorberaufhängung 15 (vorzugsweise in einem mittigen Bereich zwischen benachbarten Nachführungsringen 10) verbunden.

Gemäß dem in Fig. 9b dargestellten Ausführungsbeispiel sind zudem im Wesentlichen horizontal angeordnete Stützelemente 39 an den Nachführungsringen 10 befestigt, welche die Absorberaufhängung 15 quer zur Längsrichtung des Absorbers 2 unterstützen.

Zur Ankopplung peripherer Einheiten, wie Verdampfer, Dampfturbinen oder dergl., wird der Absorber 2 an den stirnseitigen Endbereichen des Konzentrator-Kissens 3 aus dem Hohlraum des Konzentrator-Kissens 3 geführt. Hierfür wurden bisher im Wesentlichen kreisförmige Öffnungen im Konzentrator-Kissen 3 verwendet, welche mittels eines Kunststoff-Lappens abgedichtet wurden, wodurch jedoch lediglich eine mangelhafte Abdichtung des Konzentrator-Kissens 3 erreicht werden kann.

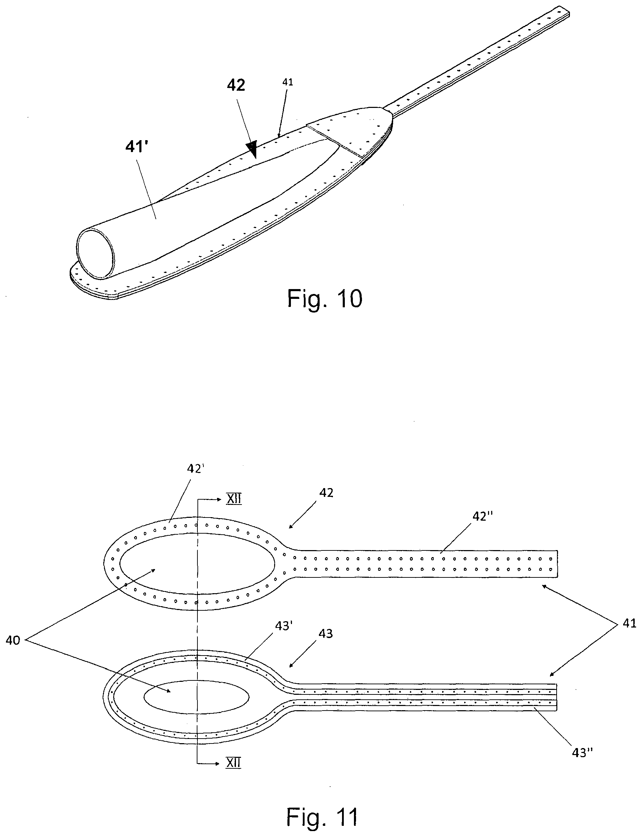

Wie aus Fig. 10 bis Fig. 14 ersichtlich, weist das Konzentrator-Kissen 3 in der gezeigten Ausführung an zumindest einem stirnseitigen Endbereich eine ovale bzw. ellipsenähnliche Durchtrittsöffnung 40 zum Durchtritt des Absorber-Rohrs 2' (vgl. Fig. 14) auf. Um einen Luftaustritt im Bereich der Durchtrittsöffnung 40 zu verhindern, ist eine Dichteinrichtung 41 vorgesehen. Wie aus Fig. 10 ersichtlich, weist die Dichteinrichtung 41 ein insbesondere aus einem Kunststoff-Material gefertigtes Durchtrittsrohr 41' auf, durch welches das Absorber-Rohr 2' (in Fig. 10 nicht gezeigt) aus dem Hohlraum 6 des Konzentrator-Kissens 3 nach außen geführt ist.

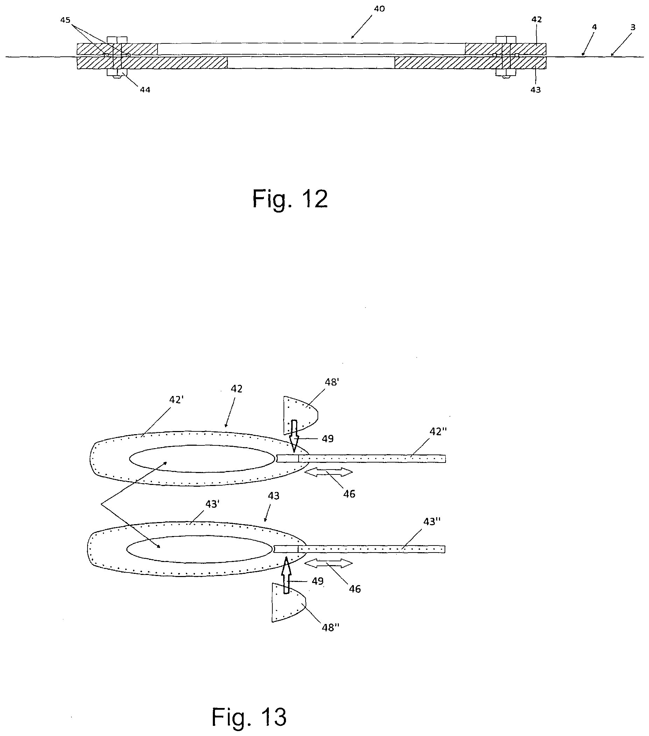

Wie aus Fig. 11 ersichtlich, weist die Dichteinrichtung 41 ein außenseitiges Klemmteil 42 und ein innenseitiges Formteil 43 auf, welches mit dem in Fig. 11 nicht gezeigten Durchtrittsrohr 41' (vgl. Fig. 14) verbunden ist. Das Klemmteil 42 und das Formteil 43 weist jeweils einen ovalen Abschnitt 42' bzw. 43' mit der Durchtrittsöffnung 40 auf, welcher in einen langgestreckten Zungenabschnitt 42'' bzw. 43'' übergeht. Die Durchtrittsöffnung 40 im Formteil 43 ist entsprechend dessen Anordnung unterhalb des Klemmteils 42 verkleinert (vgl. Fig. 12).

Wie aus Fig. 12 ersichtlich, ist zur Abdichtung der Durchtrittsöffnung 40 mittels der Dichteinrichtung 41 die transparente Folie des Eintrittsfensters 4 im Randbereich zwischen dem Formteil 43 und dem Klemmteil 42 verklemmt. Um die Dichtwirkung zu verbessern, sind beidseitig einer durch das Formteil 43 und das Klemmteil 42 durchragenden Verschraubung 44 Dichtelemente 45 vorgesehen.

Wie aus Fig. 13 schematisch ersichtlich, können der ovale Abschnitt 42' bzw. 43' und der Zungenabschnitt 42'', 43'' des Klemmteils 42 bzw. des Formteils 43 durch einzelne (insbesondere aus einem Kunststoffmaterial, beispielsweise Polycarbonat, gefertigte) Elemente gebildet sein, welche in einer vorläufigen Montageposition zueinander in Längsrichtung (vgl. Pfeil 46) verschieblich sind. Dies hat den Vorteil, dass fertigungstechnisch bedingte Toleranzen im Bereich der Durchtrittsöffnung 40 ausgeglichen werden können. Nachdem die ovalen Abschnitte 42', 43' und die Zungenabschnitte 42'', 43'' in die gewünschte Lage gebracht wurden, wird das Klemmteil 42 bzw. das Formteil 43 mittels eines Verbindungsstücks 48' bzw. 48'' (vgl. Pfeil 49) in der endgültigen Montageposition fixiert.

In Fig. 14 ist ein Längsschnitt durch das Konzentrator-Kissen 3 im Bereich des Absorberaustritts gezeigt. Aufgrund der hohen Temperaturen im Absorber-Rohr 2' können im Betrieb beträchtliche Längenänderungen auftreten, welche den luftdichten Abschluss des Konzentrator-Kissens 3 gefährden. Um den Durchtritt des Absorbers 2 durch die Durchtrittsöffnung 40 möglichst luftdicht zu gestalten, ist außerhalb des Konzentrator-Kissens 3 ein Faltenbalg 50 vorgesehen, welches beispielsweise mittels Metallschellen 51 an der Dichteinrichtung 41 (hier am mit dem Formteil 43 verbundenen Durchtrittsrohr 41') bzw. am Absorber 2 (hier am Absorber-Rohr 2') befestigt ist. Das Faltenbalg 50 passt sich im Betrieb den Längenänderungen des Absorbers 2 an, so dass ein Luftaustritt zuverlässig verhindert wird.

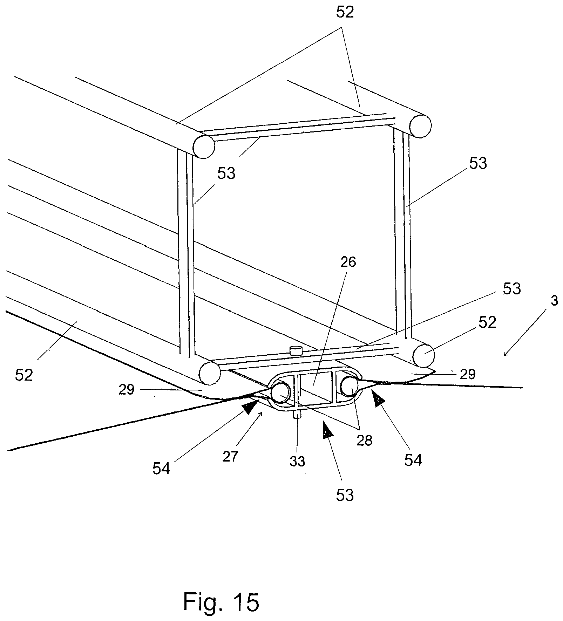

Fig. 15 zeigt eine weitere Ausführungsform der Vorrichtung 1, welche sich hinsichtlich des Aufbaus der Absorberaufhängung 15 sowie der Abdichtung der Befestigungsöffnung 26 von den vorangehenden Ausführungsbeispielen unterscheidet. Gemäß Fig. 15 weist die Trageinrichtung 16 der Absorberaufhängung 15 mehrere, in der gezeigten Ausführung vier, in Längsrichtung des Konzentratorkissens 3 verlaufende Längsträger 52 auf, welche über Querträger 53 fachwerkartig miteinander verbunden sind. Das Kedersystem 27 weist gemäß Fig. 15 ein Profilelement 53 auf, welches sich entlang der Befestigungsöffnung 26 erstreckt. Die Keder 28 sind innerhalb des Profilelements 53 aufgenommen, welches seitliche Öffnungen 54 zum Durchtritt der Kederfahnen 29 aufweist. Beim Aufblasen des Konzentratorkissens 3 werden die Kedern 28 gegen die seitlichen Innenflächen des Profilelements 53 gedrückt, wodurch die Befestigungsöffnung 26 nach außen abgedichtet wird.

## Patentansprüche

1. Vorrichtung (1) zur Konzentration von Sonnenstrahlung in einem Absorber (2), mit einem aufblasbaren Konzentrator-Kissen (3), das ein lichtdurchlässiges Eintrittsfenster (4) zum Einkoppeln der Sonnenstrahlung und eine das Konzentrator-Kissen (3) in zumindest zwei Hohlräume (6, 7) unterteilende Reflektorfolie (5) aufweist, wobei die Reflektorfolie (5) dazu eingerichtet ist, die Sonnenstrahlung in einem Absorber (2), der im einen Hohlraum (6) des Konzentrator-Kissens (3) angeordnet ist, zu konzentrieren, und mit einem außerhalb des Konzentrator-Kissens (3) angeordneten Verankerungsgerüst (8) zur Verankerung des Konzentrator-Kissens (3), wobei der Absorber (2) mittels einer Absorberaufhängung (15) an dem Verankerungsgerüst (8) befestigt ist, wobei das Konzentrator-Kissen (3) zumindest eine allseitig abgedichtete Befestigungsöffnung (26) zum Durchtritt der Absorberaufhängung (15) aufweist, wobei die Absorberaufhängung (15) eine außerhalb des Konzentrator-Kissens (3) angeordnete Trageinrichtung (16), die mit dem Verankerungsgerüst (8) verbunden ist, und eine innerhalb des Konzentrator-Kissens (3) angeordnete Absorberhalterung (17), die mit dem Absorber (2) verbunden ist, aufweist, **dadurch gekennzeichnet, dass** die außerhalb des Konzentrator-Kissens (3) angeordnete Trageinrichtung (16) und die innerhalb des Konzentrator-Kissens (3) angeordnete Absorberhalterung (17) der Absorberaufhängung (15) über die zumindest eine allseitig abgedichtete Befestigungsöffnung (26) des Konzentrator-Kissens (3) im lichtdurchlässigen Eintrittsfenster (4) miteinander verbunden sind.

2. Vorrichtung nach Anspruch 1, **dadurch gekennzeichnet, dass** die Absorberaufhängung (15) mit einem Nachführungssystem (9) des Verankerungsgerüsts (8) verbunden ist, welches dazu eingerichtet ist, das Konzentrator-Kissen (3) um zumindest eine Achse schwenkbar zu lagern.

3. Vorrichtung nach Anspruch 2, **dadurch gekennzeichnet, dass** die Absorberaufhängung (15) mit zumindest einem das Konzentrator-Kissen (3) umgebenden Nachführungsring (10), vorzugsweise mit mehreren in Längsrichtung des Konzentrator-Kissens (3) beabstandet angeordneten Nachführungsringen (10), verbunden ist.

4. Vorrichtung nach einem der Ansprüche 1 bis 3, **dadurch gekennzeichnet, dass** die Absorberaufhängung (15) in Längsrichtung des Absorbers (2) verschieblich an dem Verankerungsgerüst (8), insbesondere am Nachführungsring (10), gelagert ist.

5. Vorrichtung nach Anspruch 4, **dadurch gekennzeichnet, dass** zwischen dem Nachführungssystem (9) und der Absorberaufhängung (15) ein Lineargleitlager (22) ausgebildet ist, welches einen an dem Verankerungsgerüst (8) oder an der Absorberaufhängung (15) fixierten Schlitten (23) und eine entsprechende, an der Absorberaufhängung bzw. am Nachführungssystem fixierte Führungsschiene (24) aufweist.

6. Vorrichtung nach einem der Ansprüche 1 bis 5, **dadurch gekennzeichnet, dass** die Trageinrichtung (16) der Absorberaufhängung (15) zumindest ein rohrförmiges Tragelement (21), insbesondere mehrere jeweils an ihren Endbereichen ineinandergesteckte rohrförmige Tragelemente (21), aufweist.

7. Vorrichtung nach einem der Ansprüche 1 bis 6, **dadurch gekennzeichnet, dass** die außerhalb des Konzentrator-Kissens (3) angeordnete Trageinrichtung (16) und die innerhalb des Konzentrator-Kissens (3) angeordnete Absorberhalterung (17) der Absorberaufhängung (15) mittels einer Linearführung, insbesondere eines Lineargleitlagers (22), in Längsrichtung des Absorbers (2) zueinander verschieblich gelagert sind.

8. Vorrichtung nach einem der Ansprüche 1 bis 7, **dadurch gekennzeichnet, dass** zur Abdichtung der Befestigungsöffnung (26) des Konzentrator-Kissens (3) ein Kedersystem (27) vorgesehen ist.

9. Vorrichtung nach Anspruch 8, **dadurch gekennzeichnet, dass** ein zwischen Klemmplatten (31, 32) der Absorberaufhängung (15) wirkendes Klemmelement, insbesondere eine Schraube (33), zur Aufbringung einer Klemmkraft zwischen den Klemmplatten (31, 32) vorgesehen ist.

10. Vorrichtung nach einem der Ansprüche 1 bis 9, **dadurch gekennzeichnet, dass** zwischen dem Verankerungsgerüst (8) und der Absorberaufhängung (15) insbesondere in einem Bereich außerhalb der Verbindungen mit dem Verankerungsgerüst (8) ein Stütz- bzw. Spannsystem (37) angeordnet ist.

11. Vorrichtung nach Anspruch 10, **dadurch gekennzeichnet, dass** das Stütz- bzw. Spannsystem (37) zumindest ein insbesondere seilförmiges Spannelement (38) aufweist, dessen Enden an der Absorberaufhängung (15) bzw. an dem Verankerungsgerüst (8), insbesondere an einem mit dem Nachführungsring (10) verbundenen Stützelement (39), befestigt sind.

## Claims

1. Device (1) for concentrating solar radiation in an absorber (2), comprising an inflatable concentrator pad (3) which has a light-transmissive entry window (4) for coupling in the solar radiation and a reflective foil (5) subdividing the concentrator pad (3) into at least two cavities (6, 7), the reflective foil (5) being designed to concentrate the solar radiation in an absorber (2) which is arranged in a cavity (6) of the concentrator pad (3), and comprising an anchoring frame (8) arranged outside the concentrator pad (3) for anchoring the concentrator pad (3), the absorber (2) being fastened to the anchoring frame (8) by means of an absorber mount (15), the concentrator pad (3) comprising at least one fastening opening (26), which is sealed all around, for the absorber mount (15) to pass through, the absorber mount (15) comprising a support means (16) that is arranged outside of the concentrator pad (3) and is connected to the anchoring frame (8), and an absorber holder (17) that is arranged inside of the concentrator pad (3) and is connected to the absorber (2), **characterised in that** the support means (16) arranged outside of the concentrator pad (3) and the absorber holder (17) of the absorber mount (15) arranged inside of the concentrator pad (3) are interconnected in the light-transmissive entry window (4) by means of the at least one fastening opening (26) of the concentrator pad (3), which opening is sealed all around.

2. Device according to claim 1, **characterised in that** the absorber mount (15) is connected to a tracking system (9) of the anchoring frame (8), which system is designed to pivotally mount the concentrator pad (3) about at least one axis.

3. Device according to claim 2, **characterised in that** the absorber mount (15) is connected to at least one tracking ring (10) surrounding the concentrator pad (3), preferably to a plurality of tracking rings (10) that are spaced apart in the longitudinal direction of the concentrator pad (3).

4. Device according to any of claims 1 to 3, **characterised in that** the absorber mount (15) is mounted on the anchoring frame (8), in particular on the tracking ring (10), so as to be moveable in the longitudinal direction of the absorber (2).

5. Device according to claim 4, **characterised in that** a linear plain bearing (22) is formed between the tracking system (9) and the absorber mount (15) and comprises a slide (23) secured to the anchoring frame (8) or to the absorber mount (15) and a corresponding guide rail (24) secured to the absorber mount or tracking system.

6. Device according to any of claims 1 to 5, **characterised in that** the support means (16) of the absorber mount (15) comprises at least one tubular support element (21), in particular a plurality of support elements (21) that are inserted into one another at the respective end regions thereof.

7. Device according to any of claims 1 to 6, **characterised in that** the support means (16) arranged outside of the concentrator pad (3) and the absorber holder (17) of the absorber mount (15) arranged inside of the concentrator pad (3) are mounted so as to be moveable relative to one another in the longitudinal direction of the absorber (2) by means of a linear guide, in particular a linear plain bearing (22).

8. Device according to any of claims 1 to 7, **characterised in that** a keder system (27) is provided for sealing the fastening opening (26) of the concentrator pad (3).

9. Device according to claim 8, **characterised in that** a clamping element, in particular a screw (33), acting between clamping plates (31, 32) of the absorber mount (15) is provided for applying a clamping force between the clamping plates (31, 32).

10. Device according to any of claims 1 to 9, **characterised in that** a supporting and tensioning system (37) is arranged between the anchoring frame (8) and the absorber mount (15), in particular in a region outside of the connections to the anchoring frame (8).

11. Device according to claim 10, **characterised in that** the supporting and tensioning system (37) comprises at least one in particular rope-like tensioning element (38), the ends of which are fastened to the absorber mount (15) or to the anchoring frame (8), in particular to a supporting element (39) that is connected to the tracking ring (10).

## Revendications

1. Dispositif (1) pour la concentration du rayonnement solaire dans un absorbeur (2), avec un coussin concentrateur gonflable (3) qui comprend une fenêtre d'entrée transparente (4) pour l'entrée du rayonnement solaire et un film réflecteur (5) divisant le coussin concentrateur (3) en au moins deux cavités (6, 7), le film réflecteur (5) étant conçu pour concentrer le rayonnement solaire dans un absorbeur (2) qui est disposé dans une cavité (6) du coussin concentrateur (3) et, avec une armature d'ancrage (8) pour l'ancrage du coussin concentrateur (3), l'absorbeur (2) étant fixé au moyen d'une suspension d'absorbeur (15) à l'armature d'ancrage (8), le coussin concentrateur (3) comprenant au moins une ouverture de fixation (26) étanchéifiée de tous les côtés pour le passage de la suspension d'absorbeur (15), la suspension d'absorbeur (15) comprenant un dispositif de support (16) disposé à l'extérieur du coussin concentrateur (3), qui est relié avec l'armature d'ancrage (8), et un support d'absorbeur (17) disposé à l'intérieur du coussin concentrateur (3), qui est relié avec l'absorbeur (2),
**caractérisé en ce que**
le dispositif de support (16), disposé à l'extérieur du coussin concentrateur (3), et le support d'absorbeur (17), disposé à l'intérieur du coussin concentrateur (3), de la suspension d'absorbeur (15), sont reliés entre eux par l'intermédiaire de l'au moins une ouverture de fixation (26), étanchéifiée de tous les côtés, du coussin concentrateur (3) dans la fenêtre d'entrée transparente (4).

2. Dispositif selon la revendication 1, **caractérisé en ce que** la suspension d'absorbeur (15) est reliée avec un système orienteur (9) de l'armature d'ancrage (8), qui est conçu pour loger de manière pivotante le coussin concentrateur (3) autour d'au moins un axe.

3. Dispositif selon la revendication 2, **caractérisé en ce que** la suspension d'absorbeur (15) est reliée avec au moins un anneau d'orientation (10) entourant le coussin concentrateur (3), de préférence avec plusieurs anneaux d'orientation (10) disposés à une certaine distance dans la direction longitudinale du coussin concentrateur (3).

4. Dispositif selon l'une des revendications 1 à 3, **caractérisé en ce que** la suspension d'absorbeur (15) est logée de manière coulissante dans la direction longitudinale de l'absorbeur (2) sur l'armature d'ancrage (8), notamment au niveau de l'anneau d'orientation (10).

5. Dispositif selon la revendication 4, **caractérisé en ce que**, entre le système orienteur (9) et la suspension d'absorbeur (15), est formé un palier de guidage linéaire (22) qui comprend un chariot (23) fixé à l'armature d'ancrage (8) ou à la suspension d'absorbeur (15) et un rail de guidage (24) fixé à la suspension d'absorbeur ou au système orienteur.

6. Dispositif selon l'une des revendications 1 à 5, **caractérisé en ce que** le dispositif de support (16) de la suspension d'absorbeur (15) comprend au moins un élément de support tubulaire (21), plus particulièrement plusieurs éléments de support tubulaires (21) emboîtés les uns dans les autres au niveau de leurs extrémités.

7. Dispositif selon l'une des revendications 1 à 6, **caractérisé en ce que** le dispositif de support (16) disposé à l'extérieur du coussin concentrateur (3) et le support d'absorbeur (17), disposé à l'intérieur du coussin concentrateur (3), de la suspension d'absorbeur (15) sont logés de manière coulissante entre eux au moyen d'un guidage linéaire, plus particulièrement d'un palier de guidage linéaire (22), dans la direction longitudinale de l'absorbeur (2).

8. Dispositif selon l'une des revendications 1 à 7, **caractérisé en ce que**, pour l'étanchéification de l'ouverture de fixation (26) du coussin concentrateur (3), un système à bourrelet (27) est prévu.

9. Dispositif selon la revendication 8, **caractérisé en ce qu'**un élément de serrage agissant entre des plaques de serrage (31, 32) de la suspension d'absorbeur (15), plus particulièrement une vis (33), est prévu pour l'application d'une force de serrage entre les plaques de serrage (31, 32).

10. Dispositif selon l'une des revendications 1 à 9, **caractérisé en ce que**, entre l'armature d'ancrage (8) et la suspension d'absorbeur (15), plus particulièrement dans une zone à l'extérieur des liaisons avec l'armature d'ancrage (8), est disposé un système d'appui ou de tension (37).

11. Dispositif selon la revendication 10, **caractérisé en ce que** le système d'appui ou de tension (37) comprend au moins un élément de tension (38), plus particulièrement en forme de câble, dont les extrémités sont fixées à la suspension d'absorbeur (15) ou à l'armature d'ancrage (8), plus particulièrement à un élément d'appui (39) relié avec l'anneau d'orientation (10).
